# FASCICULE DE BREVET EUROPEEN

(11) **EP 3 853 906 B1**
(45) Date de publication et mention de la délivrance du brevet: **20.07.2022**
(21) Numéro de dépôt: 19786848.2
(22) Date de dépôt: 06.09.2019
(51) Int. Cl.: H01L 29/16, H01L 21/336

(54) **DISPOSITIF D'AMELIORATION DE LA MOBILITE DES PORTEURS DANS UN CANAL DE MOSFET SUR CARBURE DE SILICIUM**
VORRICHTUNG ZUR VERBESSERUNG DER BEWEGLICHKEIT VON LADUNGSTRÄGERN IN EINEM MOSFET-KANAL AUF SILIZIUMKARBID
DEVICE FOR IMPROVING THE MOBILITY OF CARRIERS IN A MOSFET CHANNEL ON SILICON CARBIDE

(30) Priorité: 17.09.2018 FR 1800976
(43) Date de publication de la demande: 28.07.2021
(73) Titulaire: Ion Beam Services, 13790 Peynier (FR); CNM - CSIC, 08193 Barcelona (ES)
(72) Inventeur: TORREGROSA, Frank, 13109 SIMIANE (FR); ROUX, Laurent, 13013 MARSEILLE (FR); GODIGNON, Philippe, 08197 VALLDOREIX (ES)
(74) Mandataire: IP Trust
(86) Numéro de dépôt international: PCT/FR2019/052055
(87) Numéro de publication internationale: WO 2020/058597

(56) Documents cités:
- JP-A- 2004 111 614
- US-A1- 2007 215 954
- US-B1- 6 482 704
- US-B1- 6 639 273

## Description

La présente invention concerne un dispositif d'amélioration de la mobilité des porteurs dans un canal de MOSFET sur carbure de silicium.

Le domaine de l'invention est celui des composants électroniques de puissance réalisés sur carbure de silicium (SiC) car ce matériau présente une grande vitesse de saturation des porteurs et une très bonne conductivité thermique. Parmi ces composants on dénombre les diodes, les thyristors, les transistors bipolaires, les mosfets et, plus récemment, les transistors bipolaires à grille isolée dits « IGBT » (Insulated Gate Bipolar transistor en terminologie anglaise).

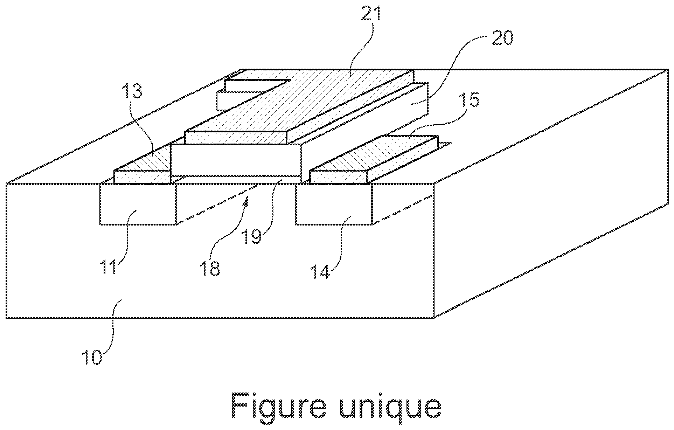

Le brevet US 6 639 273 divulgue ainsi un dispositif MOSFET sur substrat SiC comprenant une région de canal 50 (p- channel région) à faible concentration en dopant de type P entre une région de source 43 et une région de drain 44 chacune de type N (D1, colonne 5 lignes 49 à 61, figure 1a). Un diélectrique de grille 45 (gate insulating layer) est formé directement sur la région de canal 50.

Il apparaît cependant que, pour les composants du type MOSFET ou IGBT, la mobilité des porteurs dans le canal est faible comparée à celle qui règne au cœur du matériau. Il s'ensuit une limitation de la capacité en courant de ces composants. Ceci est du à une forte densité d'états d'interface entre le SiC et l'oxyde de grille en SiO₂. Ces états d'interface sont dus à la présence de défauts tels que des clusters de carbone ou bien de défauts dans la couche d'interface sous l'oxyde qui se produisent à la fin du procédé d'oxydation.

A cet égard, les chercheurs et industriels ont développé des techniques pour améliorer la qualité de cette interface SiO₂/SiC. Il est ainsi connu de pratiquer une oxydation sous oxyde d'azote NO ou N₂O et l'on pourra consulter à ce sujet :
- G. Y. Chung, C. C. Tin, J. R. Williams, K. McDonald, R. K. Chanana, R. A. Weller, S. T. Pantelides, L. C. Felldman, O. X. Holland, M. K. Das and J. W. Palmour - IEEE Electronic Device Letters 22, 176 (2001) ;
- R. Schörner, P. Friedrichs, D. Pstephani, S. Dimitrijev and P. Jamet - Applied Physics Letters 80, 4253 (2002) ;
- L. A. Lipkin, M. K. Das and J. W. Palmour - Material Science Forum 389-393, 985 (2002) ;
- K. Shiraishi et al. - First Principle Study of SiC/SiO2 Interfaces Towards Future Power Devices - International Electron Device Meeting IEDM 2014 conférence proceeding.

Ces techniques apportent des progrès mais cela reste toutefois insuffisant compte tenu des performances attendues.

Il est également connu de réaliser un post-traitement de recuit sous azote ou bien en préparant la surface du SiC par un pré-traitement en « PECVD » (Plasma Enhanced Chemical Vapor Deposition en terminologie anglaise) avant l'oxydation de grille. On consultera notamment le document CN105047539 (A) ayant pour titre « Method for improving channel mobility of SiC metal-oxide-semiconductor-field-effect-transistor (MOSFET) ».

On connaît par ailleurs l'article « Phosphorous passivation of the SiO2/4H-SiC interface » de Y. K. Sharma, A. C. Ahyi, T. Isaac-Smith, X. Shen, S. T. Pantelides, X. Zhu, L. C. Feldman and J. R. Williams paru dans Solid-State Electronics - volume 68 - February 2012 - pages 103-107. Il s'agit ici de faire un recuit dans une atmosphère chargée en P₂O₅ pour transformer la couche de SiO₂ en verre phosphosilicate (« PSG » en anglais). On améliore ici aussi la mobilité des porteurs.

Le document US 6482704 B1 divulgue un dispositif MOSFET sur substrat SiC avec des régions de source, de drain et de canal de type N.

Ici, il est nécessaire de faire un recuit avec tous les inconvénients que cela entraîne et on maîtrise mal la quantité de phosphore introduite. Cela conduit à de fortes instabilités durant le fonctionnement du composant.

La présente invention a ainsi pour objet d'augmenter significativement la mobilité des porteurs dans un canal de MOSFET sans présenter les limitations de l'état de l'art énoncées ci-dessus.

Selon l'invention, un dispositif MOSFET agencé sur un substrat comprend une première et une seconde bande fortement dopées recouvertes d'une première et d'une seconde prise de contact, ces deux bandes étant séparées par un canal figurant lui aussi sur ledit substrat, ledit canal étant recouvert d'une couche diélectrique elle-même surmontée d'une troisième prise de contact ; le dispositif est remarquable ce que le canal intègre un film mince légèrement dopé à l'interface avec la couche diélectrique, et en ce que les première et seconde bandes et le film mince présentent un même type de dopage que le canal, pour créer ainsi des charges fixes à l'interface canal/couche diélectrique afin que les porteurs soient repoussés de cette dernière et de ses défauts.

On crée ainsi des charges fixes juste à l'interface canal/couche diélectrique afin que les porteurs soient repoussés de cette dernière et de ses défauts.

Avantageusement, le substrat est en carbure de silicium.

De préférence, la couche diélectrique est en dioxyde de silicium.

Suivant un mode de réalisation privilégié, le film mince est réalisé par implantation ionique.

Ainsi, à titre d'exemple, l'implantation ionique est pratiquée en immersion plasma.

Suivant une première option, le substrat est de type P, ledit canal étant de type N.

Dans ce cas, le dopant dudit film mince est de type N.

Par exemple, le dopant est du phosphore.

Suivant une seconde option, le substrat est de type N, ledit canal étant de type P.

Dans ce cas, le dopant dudit film mince est de type P.

Par exemple, le dopant de ce film mince est du bore.

Par ailleurs, éventuellement, ce film mince est dopé avec un élément à effet dipôle.

Par exemple, cet élément à effet dipôle est du fluor.

De préférence cet élément à effet dipôle est ajouté par implantation ionique en immersion plasma.

La présente invention apparaîtra maintenant avec plus de détails dans le cadre de la description qui suit d'exemples de réalisation donnés à titre illustratif en se référant à l'unique figure jointe qui représente un schéma en perspective d'un dispositif MOSFET.

En référence à la figure, ce dispositif est réalisé sur un substrat 10 de type P dans le cas présent. Il s'agit d'un substrat massif ou bien d'une épitaxie ou bien d'une épitaxie dopée.

Sur la face supérieure de ce substrat 10 figure une première bande 11 (à gauche sur la figure) qui est fortement dopée N+. On a coutume d'appeler cette première bande le drain. Ce drain se voit appliquer une première prise de contact métallique 13.

Toujours, sur la face supérieure de ce substrat 10 figure une seconde bande 14 (à droite sur la figure) qui est elle aussi fortement dopée N+. Elle est disposée parallèlement à la première bande 11 à une certaine distance de celle-ci. On a coutume d'appeler cette seconde bande 14 la source. Cette source se voit appliquer une seconde prise de contact métallique 15.

L'espace qui figure entre le drain et la source forme un canal 18.

Classiquement, dans la technologie MOSFET, on ajoute une couche diélectrique sur le canal entre le drain 11 et la source 14. Par contre, selon l'invention, on crée un film mince 19 faiblement dopé au niveau du canal avant d'appliquer la couche diélectrique.

Avantageusement, ce film mince 19 est réalisé par implantation ionique, notamment en mode immersion plasma, ce qui a l'avantage de générer moins de défauts. Le dopage est léger, il est réalisé par exemple sous une tension d'accélération inférieure à 10 kV (typiquement 2 à 5 kV) et la dose implantée est de l'ordre de 10¹⁴/cm². Le dopant est de type N et il s'agit à titre d'exemple du phosphore. Le plasma est de préférence du PH₃ ou du PF_{X}. On peut également adopter l'arsenic à titre de dopant, auquel cas le plasma serait du type AsH₃ ou AsF_{X}.

Le dopage est isotrope et peut recouvrir les flancs d'une tranchée indépendamment de l'angle que celle-ci fait avec la surface.

Il est également souhaitable d'introduire dans le film mince 19 des éléments à effet dipôle et on pense en premier lieu au fluor. Là encore, l'introduction de ces éléments se fait par implantation ionique en immersion plasma.

Sur le film mince 19 on vient maintenant déposer une couche diélectrique 20 qui vient au droit du canal 18. Cette couche est couramment nommée oxyde de grille en terminologie MOSFET. C'est habituellement de l'oxyde de silicium réalisé par une oxydation thermique du substrat, par un dépôt chimique en phase vapeur « CVD » ( Chemical Vapor Deposition en anglais) ou une combinaison de ces deux techniques.

Il vient que le dopant du film mince 19 est réparti de chaque côté de l'interface avec le dioxyde de silicium 20.

Sur l'oxyde de grille 20 on dépose une troisième prise de contact 21 qui constitue la grille du dispositif MOSFET.

Une telle configuration apporte de gros avantages par rapport à l'état de l'art.

En premier lieu, la mobilité des porteurs dans le canal sous la grille a été multipliée par un facteur supérieur à 3.

En second lieu, le courant Drain/Source (IDS) à l'état passant a été augmenté par un facteur voisin de 10.

Jusqu'à présent, on a considéré que le dispositif était implanté sur un substrat de type P.

On peut tout à fait appliquer l'invention à un dispositif implanté sur un substrat de type N.

Dans ce cas drain et source sont fortement dopés au moyen d'un élément de type P+.

Similairement, le film mince est alors légèrement dopé avec un élément du type P tel que le bore ou l'aluminium.

Il n'est point besoin de détailler plus avant ce deuxième dispositif car l'homme du métier transpose aisément ce qui a été décrit pour le cas du substrat de type P au cas du substrat de type N.

Parallèlement, les techniques de dopage sont identiques et les plasmas éventuellement utilisés font partie de l'état de l'art qu'il s'agisse du bore ou bien de l'aluminium.

On a présenté l'invention en rapport avec des dispositifs MOSFET de traitement du signal. L'invention s'applique également aux dispositifs MOSFET de puissance verticaux ou même aux transistors « Trench ».

Les exemples de réalisation de l'invention présentés ci-dessus ont été choisis eu égard à leurs caractères concrets. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention.

## Revendications

1. Dispositif MOSFET agencé sur un substrat (10) comprenant une première (11) et une seconde (14) bande fortement dopées recouvertes d'une première (13) et d'une seconde (15) prise de contact, ces deux bandes étant séparées par un canal (18) figurant lui aussi sur ledit substrat (10), ledit canal étant recouvert d'une couche diélectrique (20) elle-même surmontée d'une troisième prise de contact (21), dispositif dans lequel les première et seconde bandes et le canal présentent un même type de dopage et un type de dopage opposé au substrat, **caractérisé en ce qu'**un film mince (19) légèrement dopé est situé à l'interface entre ledit canal (18) et la couche diélectrique (20), et **en ce que** le film mince présente le même type de dopage que les première et seconde bandes et le canal, pour créer ainsi des charges fixes à l'interface canal/couche diélectrique afin que les porteurs soient repoussés de cette dernière et de ses défauts.

2. Dispositif selon la revendication 1, **caractérisé en ce que** ledit substrat (10) est en carbure de silicium.

3. Dispositif selon l'une quelconque des revendications précédentes, **caractérisé en ce que** ladite couche diélectrique (20) est en dioxyde de silicium.

4. Dispositif selon l'une quelconque des revendications précédentes, **caractérisé en ce que** ledit substrat (10) est de type P, ledit canal (18) étant de type N.

5. Dispositif selon la revendication précédente, **caractérisé en ce que** le dopant dudit film mince (19) est de type N.

6. Dispositif selon la revendication précédente, **caractérisé en ce que** ledit dopant est du phosphore.

7. Dispositif selon l'une quelconque des revendications 1 à 3, **caractérisé en ce que** ledit substrat (10) est de type N, ledit canal (18) étant de type P.

8. Dispositif selon la revendication précédente, **caractérisé en ce que** le dopant dudit film mince (19) est de type P.

9. Dispositif selon la revendication précédente, **caractérisé en ce que** le dopant dudit film mince (19) est du bore.

10. Dispositif selon l'une quelconque des revendications précédentes, **caractérisé en ce que** ledit film mince (19) est dopé avec un élément à effet dipôle.

11. Dispositif selon la revendication précédente, **caractérisé en ce que** ledit élément à effet dipôle est du fluor.

12. Méthode de fabrication d'un dispositif selon la revendication 10 ou 11, **caractérisée en ce que** ledit élément à effet dipôle est ajouté par implantation ionique en immersion plasma.

13. Méthode de fabrication d'un dispositif selon l'une quelconque des revendications 1 à 3, **caractérisée en ce que** ledit film mince (19) est réalisé par implantation ionique.

14. Méthode de fabrication selon la revendication précédente, **caractérisée en ce que** l'implantation ionique est pratiquée en immersion plasma.

## Patentansprüche

1. MOSFET-Vorrichtung, die auf einem Substrat (10) angeordnet ist, die einen ersten (11) und einen zweiten (14) hochdotierten Streifen umfasst, die mit einer ersten (13) und einer zweiten (15) Kontaktaufnahme bedeckt sind, wobei diese zwei Streifen durch einen Kanal (18) getrennt sind, der ebenfalls auf dem Substrat (10) aufgeführt ist, wobei der Kanal mit einer Sperrschicht (20) bedeckt ist, die ihrerseits von einer dritten Kontaktaufnahme (21) überragt wird, Vorrichtung, wobei der erste und der zweite Streifen und der Kanal einen gleichen Dotierungstyp und einen dem Substrat entgegengesetzten Dotierungstyp aufweisen, **dadurch gekennzeichnet, dass** an der Grenzfläche zwischen dem Kanal (18) und der Sperrschicht (20) ein schwach dotierter dünner Film (19) gelegen ist, und dass der dünne Film den gleichen Dotierungstyp wie der erste und der zweite Streifen und der Kanal aufweist, zum Erzeugen von festen Ladungen an der Grenzfläche Kanal/Sperrschicht auf diese Art, damit die Träger von letzterer und von ihren Fehlern abgestoßen werden.

2. Vorrichtung nach Anspruch 1, **dadurch gekennzeichnet, dass** das Substrat (10) aus Siliziumkarbid besteht.

3. Vorrichtung nach einem der vorhergehenden Ansprüche, **dadurch gekennzeichnet, dass** die Sperrschicht (20) aus Siliziumdioxid besteht.

4. Vorrichtung nach einem der vorhergehenden Ansprüche, **dadurch gekennzeichnet, dass** das Substrat (10) von dem P-Typ ist, wobei der Kanal (18) von dem N-Typ ist.

5. Vorrichtung nach dem vorhergehenden Anspruch, **dadurch gekennzeichnet, dass** der Dotierungsstoff des dünnen Films (19) von dem Typ N ist.

6. Vorrichtung nach dem vorhergehenden Anspruch, **dadurch gekennzeichnet, dass** der Dotierungsstoff Phosphor ist.

7. - Vorrichtung nach einem der Ansprüche 1 bis 3, **dadurch gekennzeichnet, dass** das Substrat (10) von dem N-Typ ist, wobei der Kanal (18) von dem P-Typ ist.

8. Vorrichtung nach dem vorhergehenden Anspruch, **dadurch gekennzeichnet, dass** der Dotierungsstoff des dünnen Films (19) von dem P-Typ ist.

9. Vorrichtung nach dem vorhergehenden Anspruch, **dadurch gekennzeichnet, dass** das Dotierungsmittel des dünnen Films (19) Bor ist.

10. Vorrichtung nach einem der vorhergehenden Ansprüche, **dadurch gekennzeichnet, dass** der dünne Film (19) mit einem Element mit Dipoleffekt dotiert ist.

11. Vorrichtung nach dem vorhergehenden Anspruch, **dadurch gekennzeichnet, dass** das Element mit Dipoleffekt Fluor ist.

12. Verfahren zum Herstellen einer Vorrichtung nach Anspruch 10 oder 11, **dadurch gekennzeichnet, dass** das Element mit Dipoleffekt durch Plasmaimmersionsionenimplantation hinzugefügt wird.

13. Verfahren zum Herstellen einer Vorrichtung nach einem der Ansprüche 1 bis 3, **dadurch gekennzeichnet, dass** der dünne Film (19) durch Ionenimplantation gefertigt wird.

14. Herstellungsverfahren nach dem vorhergehenden Anspruch, **dadurch gekennzeichnet, dass** die Ionenimplantation in Plasmaimmersion durchgeführt wird.

## Claims

1. MOSFET device which is arranged on a substrate (10) comprising a first (11) and a second (14) heavily doped strip which are covered with a first (13) and a second (15) contact, these two strips being separated by a channel (18) which is also on said substrate (10), said channel being covered with a dielectric layer (20) which is itself topped by a third contact (21), device in which the first and second strips and the channel have the same type of doping and a type of doping opposite to the substrate, **characterized in that** a lightly doped thin film (19) is located at the interface between said channel (18) and the dielectric layer (20), and **in that** the thin film has the same type of doping as the first and second strips and the channel, thereby creating fixed charges at the channel/dielectric layer interface so that the carriers are repelled from said interface and its defects.

2. Device according to claim 1, **characterized in that** said substrate (10) is made of silicon carbide.

3. Device according to either of the preceding claims, **characterized in that** said dielectric layer (20) is made of silicon dioxide.

4. Device according to any of the preceding claims, **characterized in that** said substrate (10) is of the P type, said channel (18) being of the N type.

5. Device according to the preceding claim, **characterized in that** the dopant of said thin film (19) is of the N type.

6. Device according to the preceding claim, **characterized in that** said dopant is phosphorus.

7. Device according to any of claims 1 to 3, **characterized in that** said substrate (10) is of the N type, said channel (18) being of the P type.

8. Device according to the preceding claim, **characterized in that** the dopant of said thin film (19) is of the P type.

9. Device according to the preceding claim, **characterized in that** the dopant of said thin film (19) is boron.

10. Device according to any of the preceding claims, **characterized in that** said thin film (19) is doped with a dipole effect element.

11. Device according to the preceding claim, **characterized in that** said dipole effect element is fluorine.

12. Method for producing a device according to either claim 10 or claim 11, **characterized in that** said dipole effect element is added by ion implantation in plasma immersion.

13. Method for producing a device according to any of claims 1 to 3, **characterized in that** said thin film (19) is produced by ion implantation.

14. Production method according to the preceding claim, **characterized in that** the ion implantation is carried out in plasma immersion.
